# EUROPEAN PATENT SPECIFICATION

(11) **EP 1 221 012 B1**
(45) Date of publication and mention of the grant of the patent: **09.06.2004**
(21) Application number: 00961295.3
(22) Date of filing: 05.09.2000
(51) Int. Cl.: F24J 2/16, F24J 2/34, H01L 31/052

(54) **CASCADE UTILIZATION OF SUNLIGHT ENERGY**
KASKADISCHE VERWENDUNG VON SONNENENERGIE
UTILISATION EN CASCADE DE L'ENERGIE DE LA LUMIERE SOLAIRE

(30) Priority: 06.09.1999 SE 9903128
(43) Date of publication of application: 10.07.2002
(73) Proprietor: Ekvitec AB, 113 60 Stockholm (SE)
(72) Inventor: HEDEN, Carl-Göran, S-171 64 Solna (SE)
(74) Representative: Bjelkstam, Peter
(86) International application number: PCT/SE2000/001702
(87) International publication number: WO 2001/018460

(56) References cited:
- DE-A1- 19 737 344
- US-A- 4 278 829
- US-A- 4 733 506
- US-A- 5 356 487
- US-A- 5 522 944
- US-A- 5 575 860

## Description

The present invention refers to a device according to the preamble of claim 1.

Increased efficiency of solar cells of the thin film variety and improved possibilities for large scale production both of CIS- and Grätzelcells, brings up the question of how such cells can best be integrated with the climatizing-, illumination- and recycling systems in different types of buildings. A natural starting point is then not only to protect those delicate cells agains rain, snow, ice and dust, but also to prevent a heating which could reduce the efficiency of the cells.

The object of the present invention is now to effect an efficient protection of those delicate cells against rain, snow, ice and dust and also to prevent a heating which reduces their efficiency.

In this connection it is characteristic for the invention that the solar cells are mounted directly on beams included in the device, said beams are longitudinal and placed on their edge and parallelly orientated at a predetermined distance from each other, in said beams are channels for cooling and for removal of produced heat by means of a circulating gas, liquid or a solar heated vaporizeable medium, which later is condensed in a heat storage space. The beams with attached solar cells are protected between a transparent, outer cover of plastic or glass and and an under-roof also of a transparent material, said under-roof constitutes the upper limit of a space, the floor of which serves as a heat storage at the same time as the lower parts of the beams by means of hinges support up-and-down movable panels.

In a preferred embodiment form of the invention the movable panels have a height which corresponds to half the distance between the beams. In addition the panels can be manufactured from reflecting and insulating material and be positioned by means of a special guide-program.

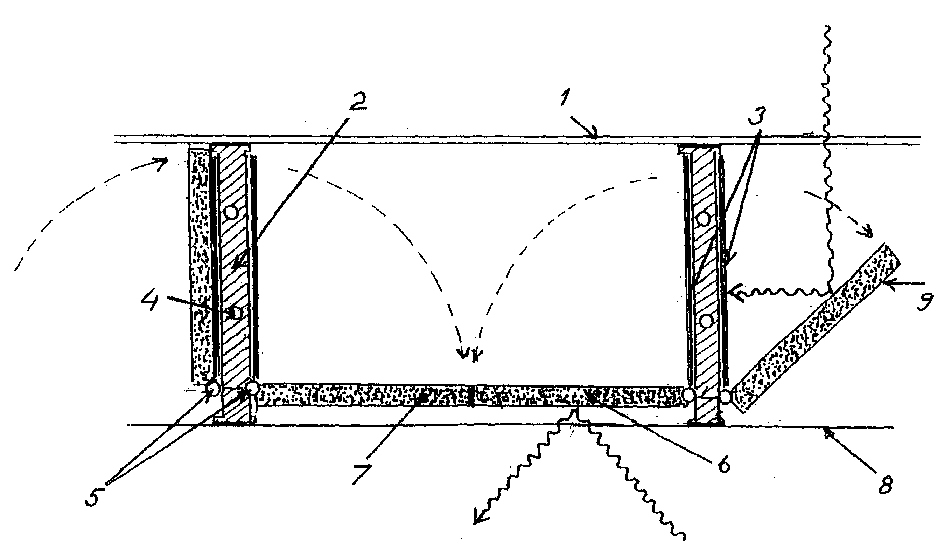

The invention is described below in more detail by means of a preferred embodiment example, which refers to the attached drawing, which shows a schematic partial cross section of the device according to the invention.

In accordance with the invention the drawing shows a preferred embodiment example of a shelter for solar cells 3 formed such as a transparent outer shell 1, preferably of plastic or glass, over hollow, vertical beams 2, for instance made of black anmodized aluminium, on which solar cells 3 have been attached, and an under-roof 8 arranged under the beams 2 preferably a plastic foil. By this arrangement the solar cells 3 can efficiently be cooled by means of a gas or non-freezing liquid medium, which circulates through channels 4 in the beams 2, from which any medium selected for evaporation by solar heat can reach a heat storage space for condensation and subsequent recycling. In this way not only electricity but also heat can be stored, which makes it possible to balance the needs for electricity, heating/cooling and illumination under a so-called "climate shell". This can be achieved by heat pump technology and elongated, movable panels 6, 7, which are mounted on hinges along the lower edge of the vertical beams 2.

The panels 6, 7, which can be elongated, movable shiny screens, are intended to reflect sunlight towards the solar cells 3. They are manufactured from a heat insulating material and their positioning 9 is guided according to an earlier known principle which is described in detail in United States patent 4, 733, 506. The lower edges of the beams 2 provide a hold for said under-roof 8 formed by a plastic foil, which protects the space below from downdraft, at the same time as said under-roof 8 acts as a shield against dust and represents the ceiling of a space, the floor of which acts as a heat storage space.

The panels 6, 7 with their reflecting surfaces, which during the night are intended to prevent heat losses, are caused to assume positions 9 during the daytime, giving an optimal distribution between el-heatstorage, indoor illumination and comfort. This creates new conditions for climate shells, which for instance make it possible to control a local water management and various organic waste cycles.

The positions 9 of the panels 6, 7 can be determined by a guide-program, which continuously optimizes the balance between electricityy production, climatizing and illumination - by integrating object-specific data (the geographic locationt: lat.- long, the compass direction of the transparent surfaces, the basic building geometry, the annual climate profile and the costs for external energy inputs) with the time, date and other local and momentary conditions such as the difference between the outdoor and indoor temperatures and remaining heat storage capacity.

The optimizing problems are of different types namely technical and economical and their solution provides good opportunities to penetrate different markets, where good illumination can be combined with enclosed modularized units suitable for industrial production. The latter can be very simple and flexible since they need not involve considerations of snowloads, windpressures and barrier needs, which normal buildings require.

## Claims

1. A supporting and protecting device of solar cells, preferably of the thin-film variety, for use in various types of buildings, **characterized in that** the solar cells (3) are mounted directly on elongated beams (2), parallelly orientated at a predetermined distance from each other and placed on their edge, in said beams (2) there are channels (4) for cooling and removal of produced heat by means of a circulating gas, liquid or a solar heated vaporizeable medium, which later is condensed in a heat storage space, said beams (2) having the solar cells (3) being protected by at least one transparent, outer cover (1) of plastic and/or glass, arranged over them, at the same time as the lower parts of the beams (2) by means of hinges (5) support up-and-down movable panels (6, 7).

2. A device according to claim 1 , **characterized in that** the beams (2) with attached solar cells (3) are protected between the transparent outer cover (1) and an under-roof (8) also of a transparent material.

3. A device according to claim 1, **characterized in that** the movable panels (6,7) have a heigh corresponding to half the distance between the beams (2).

4. A device according to claim 1, **characterized in that** the panels (6,7) are manufactured from a reflecting and heat insulating material.

5. A device according to claim 1, **characterized in that** the position of the panels (6,7) is adjustable by means of a guide-program.

6. A device according to claim 1, **characterized in that** the circulating medium is resistant to freezing.

## Patentansprüche

1. Vorrichtung zur Abstützung und zum Schutz von Solarzellen, vorzugsweise des Typs mit einem Dünnfilm, zur Verwendung bei verschiedenen Gebäudetypen, **dadurch gekennzeichnet, dass** die Solarzellen (3) direkt auf länglichen Trägern (2) montiert sind, mit einem vorbestimmten Abstand voneinander parallel orientiert und an ihrer Kante platziert, wobei in den besagten Trägern (2) Kanäle (4) für eine Kühlung und Ableitung der erzeugten Hitze mittels eines zirkulierenden Gases, einem Fluid oder einem durch Solarhitze verdampfbaren Medium vorhanden sind, welches später in einem Hitzespeicherraum kondensiert wird, wobei die besagten Träger (2), welche die Solarzellen (3) aufweisen, durch wenigstens eine über ihnen angeordnete transparente äußere Abdeckung (1) aus Kunststoff und / oder Glas geschützt sind und gleichzeitig die unteren Teile der Träger (2) auf- und abbewegliche Tafeln (6,7) mittels Scharnieren (5) abstützen.

2. Vorrichtung nach Anspruch 1, **dadurch gekennzeichnet, dass** die Träger (2) mit den daran befestigten Solarzellen (3) zwischen der transparenten äußeren Abdeckung (1) und einem unteren Dach (8) ebenfalls aus einem transparenten Material geschützt sind.

3. Vorrichtung nach Anspruch 1, **dadurch gekennzeichnet, dass** die beweglichen Tafeln (6, 7) eine Höhe entsprechend einer Hälfte des Abstandes zwischen den Trägern (2) haben.

4. Vorrichtung nach Anspruch 1, **dadurch gekennzeichnet, dass** die Tafeln (6, 7) aus einem reflektierenden und hitzeisolierenden Material hergestellt sind.

5. Vorrichtung nach Anspruch 1, **dadurch gekennzeichnet, dass** die Position der Tafeln (6, 7) durch ein Führungsprogramm verstellbar ist.

6. Vorrichtung nach Anspruch 1, **dadurch gekennzeichnet, dass** das zirkulierende Medium gegen ein Gefrieren resistent ist.

## Revendications

1. Dispositif pour supporter et protéger des piles solaires, de préférence du type à film mince, destinées à être utilisées dans divers types de bâtiments, **caractérisé en ce que** les piles (3) solaires sont montées directement sur des poutres (2) oblongues, alignées parallèlement à une distance déterminée à l'avance les unes des autres et placées sur leur bord, il y a dans ces poutres (2) des canaux (4) de refroidissement et d'évacuation de la chaleur produite au moyen d'un gaz, d'un liquide ou d'un fluide, vaporisable sous l'effet de la chaleur solaire, en circulation, ce dernier étant condensé dans un espace d'emmagasinage de la chaleur, les poutres (3) ayant les piles (3) solaires étant protégées par au moins un couvercle (1) transparent, extérieur, en matière plastique ou en verre, placé sur elles en même temps que les parties inférieures des poutres (2) supportent, au moyen de charnières (5), des panneaux (6, 7) mobiles, pouvant être soulevés et abaissés.

2. Dispositif suivant la revendication 1, **caractérisé en ce que** les poutres (2) ayant des piles (3) solaires qui sont fixées sont protégées entre le couvercle (1) transparent extérieur et un sous-toit (8) également en matériau transparent.

3. Dispositif suivant la revendication 1, **caractérisé en ce que** les panneaux (6, 7) mobiles ont une hauteur correspondant à la moitié de la distance entre les poutres (2).

4. Dispositif suivant la revendication 1, **caractérisé en ce que** les panneaux (6, 7) sont en un matériau de réfléchissant et isolant thermiquement.

5. Dispositif suivant la revendication 1, **caractérisé en ce que** la position des panneaux (6, 7) est réglable au moyen d'un programme guide.

6. Dispositif suivant la revendication 1, **caractérisé en ce que** le fluide en circulation résiste à la congélation.
